# EUROPEAN PATENT SPECIFICATION

(11) **EP 1 502 485 B1**
(45) Date of publication and mention of the grant of the patent: **02.11.2011**
(21) Application number: 03712605.9
(22) Date of filing: 22.04.2003
(51) Int. Cl.: H05G 2/00

(54) **METHOD OF GENERATING EXTREME ULTRAVIOLET RADIATION**
VERFAHREN ZUR ERZEUGUNG VON EXTREM-ULTRAVIOLETT-STRAHLUNG
PROCEDE DE PRODUCTION DE RAYONNEMENT ULTRAVIOLET EXTREME

(30) Priority: 30.04.2002 DE 10219173
(43) Date of publication of application: 02.02.2005
(73) Proprietor: Philips Intellectual Property & Standards GmbH, 20099 Hamburg (DE); Koninklijke Philips Electronics N.V., 5621 BA Eindhoven (NL)
(72) Inventor: DERRA, Günther Hans, c/o Philips IP & Standards GmbH, 52066 Aachen (DE); NIEMANN, Ulrich, c/o Philips IP & Standards GmbH, 52066 Aachen (DE)
(74) Representative: Meyer, Michael Josef
(86) International application number: PCT/IB2003/001611
(87) International publication number: WO 2003/094581

(56) References cited:
- DE-B3- 10 260 458
- US-B1- 6 180 952
- PATENT ABSTRACTS OF JAPAN vol. 2000, no. 06, 22 September 2000 (2000-09-22) & JP 2000 091096 A (NIKON CORP), 31 March 2000 (2000-03-31)
- BERGMANN K ET AL: "An extreme ultraviolet radiation source based on a gas discharge plasma" PULSED POWER CONFERENCE, 1999. DIGEST OF TECHNICAL PAPERS. 12TH IEEE INTERNATIONAL MONTEREY, CA, USA 27-30 JUNE 1999, PISCATAWAY, NJ, USA,IEEE, US, 27 June 1999 (1999-06-27), pages 283-286, XP010371211 ISBN: 0-7803-5498-2
- EVEN-ZOHAR M ET AL: "A study of EUV spectra in the fifth period" JOURNAL OF PHYSICS B (ATOMIC AND MOLECULAR PHYSICS), AUG. 1972, UK, vol. 5, no. 8, pages 1596-1613, XP002250665 ISSN: 0022-3700

## Description

The invention relates to a method of generating extreme ultraviolet radiation, wherein the radiant medium is a plasma generated from a basic material distribution.

Such methods are known. They are used, for example, in lithographic projection for the manufacture of semiconductors. For future generations of lithographic projection, an intensive light source for short-wave radiation in the extreme ultraviolet range, hereinafter referred to as EUV, from approximately 5 to 50 nm is required. To be precise, as a result of the availability of efficient multilayer reflectors, the most promising concepts will employ a very narrow wavelength band in the 13.5 nm range. Generally speaking, the aim is to obtain an EUV light source for lithographic applications, which has a high, overall, usable EUV output in the range from 50 W to 100 W, which output is available upon entering the illumination optical systems, and is necessary to fulfill the throughput conditions of the lithographic process.

In order to be able to fulfill these extremely high requirements, a high overall efficiency of the system is required. The most important factors in respect of the light source are compactness of the radiant volume and a high conversion efficiency of electric input power to EUV radiation.

Various concepts enabling said objects to be achieved are commonly known: synchrotron X-ray sources, laser-produced plasmas, hereinafter referred to as LPP, and discharge sources.

Synchrotron X-ray sources have several disadvantages, which are unacceptable if said sources are to be integrated in a semiconductor manufacturing process. These drawbacks relate to the fact that they are extremely expensive and to substantial requirements regarding the space and/or the position occupied by the source and the associated surrounding equipment.

The sources for laser-generating the plasma for the EUV range employ high-power laser beams which are focused on gaseous, liquid or solid targets and generate a hot plasma emitting the EUV radiation.

The most important drawback of the currently proposed systems is the strong formation of impurities in the form of ions, atoms or particles, which are emitted by the plasma region.

This may result in a rapid degradation of the EUV radiation-collection optics. This problem is most critical for solid targets, but is serious also in the case of liquid or gaseous targets, which are generally emitted by a specific type of nozzle. The oxygen and xenon targets which are most commonly used with LPPs lead to the problem that a conversion efficiency from electric input power to usable EUV output power of approximately 0.25% is achieved, which is very low.

To achieve the necessary EUV levels, a laser beam output of many kilowatts with a pulse frequency above 1 kHz is necessary. These laser systems are not available at present and even if they were available, as a result of dramatic development efforts, they would be very expensive.

Finally, discharge sources generate EUV radiation by means of an electrically driven discharge plasma. Various concepts are currently under discussion, for example capillary discharges, z-pinch discharges as well as hollow cathode-triggered discharges as disclosed, for example, in DE 199 22 566.

The main advantages of the discharge sources are their compactness, comparatively low costs as well as a direct conversion of the stored electric energy, leading to the formation of a hot plasma that generates EUV.

For most LPP and discharge EUV sources xenon is used as the radiant medium. In spite of the comparatively high conversion efficiency in comparison with other radiant gases, the absolute conversion efficiency for Xe sources is approximately 0.5% at the most. Taking into account substantial EUV light losses inside the light-collection and light-projection optical systems as well as the EUV intensity necessary at wafer level, the source must supply approximately 100W EUV power from a very small radiant volume. Division of the necessary power by the conversion efficiency indicated above results in a necessary input power for all Xe sources of at least 20 kW, which power must be supplied by a laser or by an electric discharge. This leads to serious technological problems.

The conditions to be fulfilled by the laser system or the electrode discharge system can be noticeably eased if radiators that are much more effective can be used in the plasma-forming process.

Various authors proposed the use of lithium-metal vapor as a high-efficiency EUV radiator. For example Partlo et al. in US patents 6,064,072, 6,051,841, 5,763,930, Silfvast et al. in US patents 6,031,241, 5,963,616, 5,499,282 and WO 99/34395. Also tin was proposed as an efficient EUV radiator for laser-generated plasma sources, for example, by T. Tomie et al. in Second Int. Sematec, a Workshop on EUV Lithography, San Francisco, October 2000.

In accordance with the prior art described above, only metal vapors from lithium or tin were used as the radiant medium. It is know, however, that the evaporation of lithium requires very high temperatures of the discharge system. The evaporation of tin requires even higher temperatures, which cannot easily be realized in a possible gas discharge source. The metal vapors will be available not only in the plasma volume but also in at least a part of the inner volume of the source. If the inner parts of the source, which are in contact with the metal vapor, are not hot enough, condensation of the metal occurs. This will most probably lead to a rapid system error. Even if condensation can be precluded, serious other problems relating to corrosion of the inner parts of the source caused by the hot metal vapor could occur, which is commonly know particularly in the case of lithium.

Therefore, it is an object of the invention to provide a method of the type mentioned in the opening paragraph, which enables reliable plasma production for EUV generation using simple technical means and avoids prior art drawbacks.

In the method of the type mentioned in the opening paragraph this object is achieved in accordance with the invention in that the basic material distribution of the radiant medium comprises at least one evaporated halogenide of the metals lithium (Li), indium (In), tin (Sn), antimony (Sb), tellurium (Te), aluminum (Al), with the exception of halogenides on the basis of lithium (Li) and chlorine (C1) as well as fluorine (F).

The use of said media to generate EUV radiation by means of a plasma has the important advantage that a predetermined vapor pressure can be generated at a temperature that is substantially lower than the temperature that is required if pure metal vapors are used. This leads to a substantial reduction of the necessary power. If, however, the plasma must be generated at a specific temperature, then this can be carried out by means of the media in accordance with the invention at a substantially higher vapor pressure.

In accordance with a further advantageous embodiment of the invention, EUV radiation in the range from approximately 5 nm to approximately 50 nm is generated. It is thus ensured that the wavelength necessary for lithography is attained.

Furthermore, the generation of a plasma with an electron temperature of at least 10 eV corresponding to approximately 116,000 K is advantageously made possible. As a result, effective radiation in the EUV range is achieved.

In accordance with a further advantageous embodiment, at least an inert gas is added to the basic material distribution.

To further increase the temperature advantage, it is advantageous to add at least a further halogenide as a so-termed "evaporator" to the basic material distribution.

It is particularly advantageous if said further halogenide is a metal-based halogenide.

In order to further reduce the risk of condensation and/or corrosion of the plasma-generating assembly, it may be advantageous to add at least a pure halogen to the basic material distribution in a quantity such that an oversaturation condition of the halogen is obtained.

To achieve a high optical efficiency of the lithographic illumination and projection optical system, it is advantageously proposed that the emission volume of the extreme ultraviolet principal radiation is below 30 mm³.

Furthermore, in accordance with an embodiment of the invention, the extreme ultraviolet radiation is emitted in a wavelength range from 10 to 15 nm.

This is advantageous in particular for newer generation-lithographic processes wherein Mo-Si multilayer mirrors are used.

Furthermore, the means used for generating the EUV radiation-emitting plasma volume is a discharge taking place between two electrodes.

In accordance with the invention it is also possible that the means for generating the EUV radiation-emitting plasma volume is at least one laser beam.

It is particularly advantageous if the mean pressure of the metal halogenide, the iodine or another metal halogenide lies in the range from approximately 1 to 1000 Pa.

Furthermore, it is advantageously possible for the plasma to be generated in the pulsed mode; however it may alternatively be generated in the continuous mode of operation.

It is additionally possible that the plasma is generated by a hollow cathode-triggered discharge.

In accordance with a further embodiment of the method, the plasma is formed by a pinch discharge.

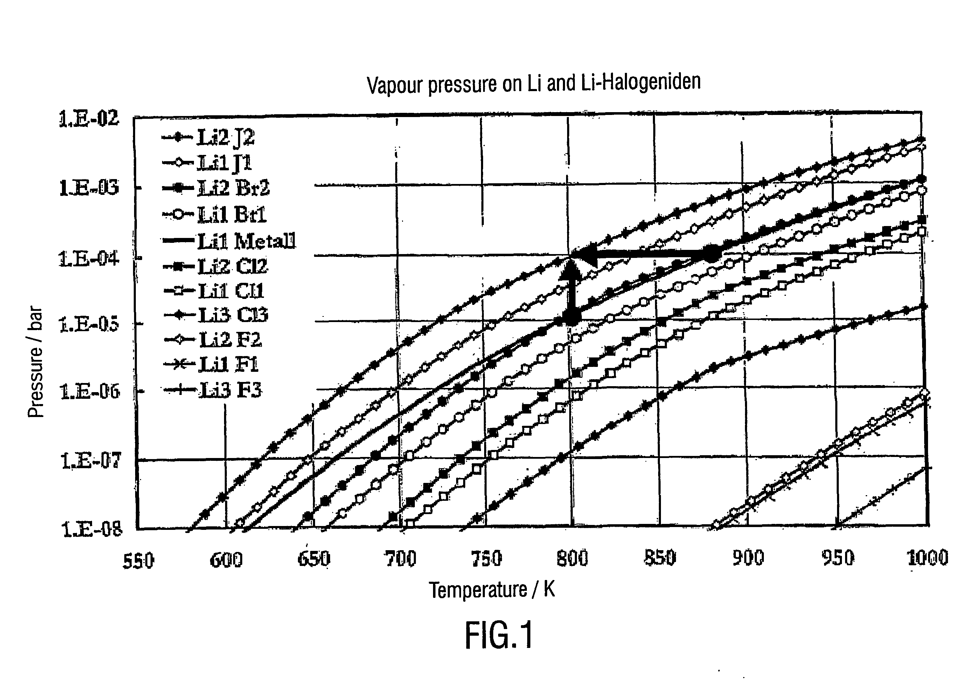

WO 01/99143 A1 discloses the formation ofhalogenides on the basis of lithium with chlorine and fluorine. However, these halogenides exhibit clearly worse vapor pressures than pure lithium. This is shown, inter alia, in Fig. 1.

These and other aspects of the invention are apparent from and will be elucidated with reference to the embodiment(s) described hereinafter.

In the drawings:
Fig. 1 shows vapor pressures of metallic lithium and lithium halogenides in dependence upon the temperature;
Fig. 2 shows vapor pressures of metallic tin and tin halogenides plotted versus temperature;
Fig. 3 shows vapor pressures of different EUV-emitting halogenides and pure iodine plotted versus temperature;
Fig. 4 shows examples of the gas phase.composition versus vapor pressures in the case of a mixture of lithium bromide and tin iodide phases of equal molar quantity; and
Fig. 5 shows examples of the gas phase composition versus vapor pressures in the case of a mixture of lithium iodide and aluminum iodide phases of equal molar quantity.

Hereinbelow a description is given of various examples, with reference to Figs. 1 to 5, wherein inter alia the chemical equilibriums of complex gas phases lead to novel attractive possibilities by means of which the problems in connection with metallic lithium or metallic tin vapor can be reduced substantially, if not completely. Novel possibilities of EUV radiators are given which are based on lithium, tin or other compounds, or also on pure elements.

As partly set forth hereinabove, it is an object of the invention to provide:
novel methods of using lithium (Li) as a radiator in an EUV source;
novel methods of using tin (Sn) as a radiator in an EUV source;
novel methods of using lithium (Li) and tin (Sn) as radiators in an EUV source at temperatures below those required for a pure metal compound;
novel methods of using lithium (Li) and tin (Sn) as radiators in an EUV source, leading to a reduced risk of corrosion as compared to that when use is made of pure metals; and
novel methods of using other elements of the fifth period of the periodic system as efficient EUV radiators.

These objects were achieved, inter alia, by supplying the discharge source with lithium (Li) and tin (Sn) not in the form of pure metal vapor but in the form of various lithium or different halogenides, whether or not together with other existing metallic halogenides.

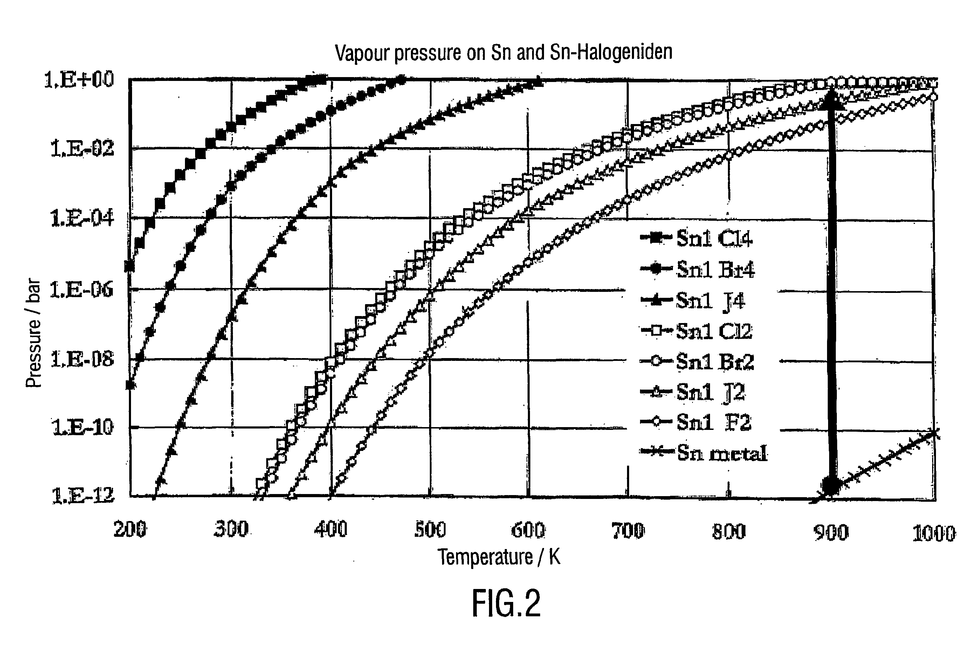

First the vapor pressure of individual lithium and tin halogenides is considered. As shown in Figs. 1 and 2, the vapor pressure of the halogenides of lithium and tin can be much higher than that of pure metals. In the case of lithium shown in Fig. 1, for example lithium iodide can be used as the radiation medium, which is present in the gas phase as a monomer (LiJ)-dimer (Li₂J₂) equilibrium. An overall pressure of lithium-containing elements of the order of 10⁻⁴ to 10⁻³ bar, which is a typical pressure range for the generation of EUV by means of gas discharge cells, can be attained at a temperature that is approximately up to 90 K lower than that necessary for the evaporation of pure metal. At a specific temperature, the overall pressure of the lithium-containing elements is one order of magnitude higher than the vapor pressure of the pure metal in the corresponding temperature zone.

The halogenides shown in Fig. 1 are Li₂J₂, Li₁J₁, Li₂Br₂ and Li₁Br₁, which are compared with the pure metal Li. As shown in Fig. 1, the dimer of lithium iodide, i.e. Li₂J₂ is most advantageous. The vapor pressure values of the halogenides on the basis of lithium and chlorine or fluorine however are clearly worse than the vapor pressure of pure lithium.

As regards the use of tin in the case shown in Fig. 2, a vapor pressure of 10⁻⁴ to 10⁻³ bar can be attained using, for example, tin chloride (SnCl₂) or tin bromide (SnBr₂) at a temperature in the range from approximately 550 K to 600 K. In the case of quadrivalent tin halogenides, for example SnCl₄, SnBr₄ and SnJ₄, this can even be attained at temperatures below 400 K. This temperature is very much lower than the temperature necessary for the evaporation of the pure metal. At a specific temperature, approximately 900 K in the case shown in Fig. 2, the vapor pressure of SnCl₂ or SnBr₂ is more than 10 orders of magnitude higher than that of pure tin metal.

Fig. 2 shows the halogenides tin fluoride (SnF₂), tin chloride (suCl₂) and (SnCl₄), tin bromide (SnBr₂) and (SnBr₄) as well as tin iodide (SnJ₂) and (SnJ₄) versus pure tin metal.

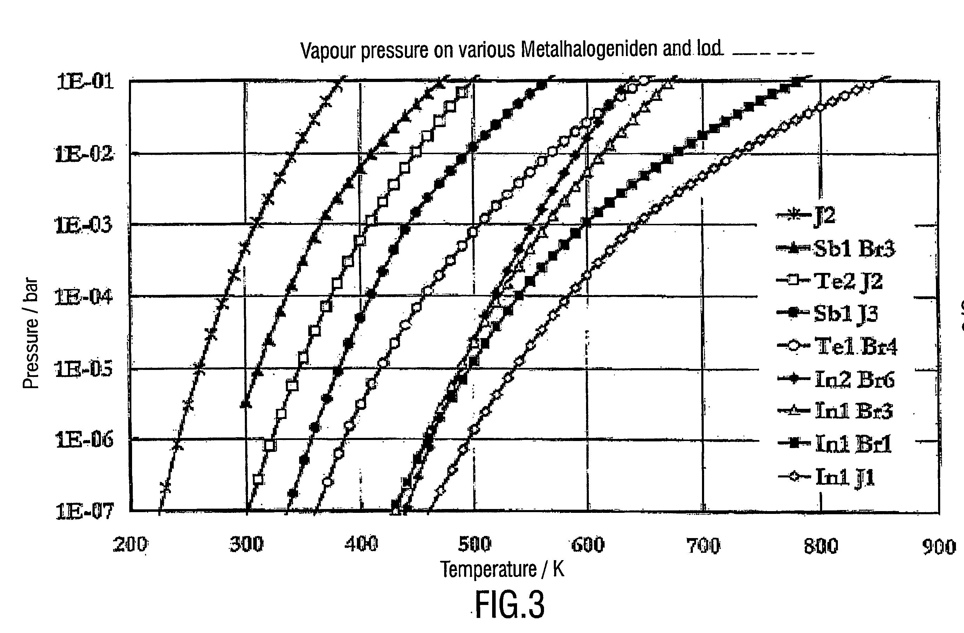

As is also shown in Fig. 3, in addition to the halides or halogenides of lithium or/and tin which are known to be used as EUV radiators, also other halogenides can be used as efficient EUV radiators. In particular the elements indium (In), antimony (Sb) and tellurium (Te) show radiation bands in the EUV range. Also for these elements there are halogenides with a high vapor pressure, which leads to a simplified evaporation of sufficiently large quantities in the discharge volume. The temperatures necessary to evaporate sufficient metal halogenide for an EUV-emitting plasma range between 300 K and 600 K.

In addition to said metal halogenides, also elementary iodine (J) can be used as an EUV radiator. The vapor pressure of iodine is very high even at room temperature (cf. Fig. 1). As a result, also a pure halogen can be used as an attractive radiator.

The halogenides shown in Fig. 3 are antimony bromide (SbBr₃), tellurium iodide (Te₂J₂), antimony iodide (SbJ₃), tellurium bromide (TeBr₄), indium bromide (InBr, InBr₃, InBr₆), indium iodide (InJ) and, compared to pure iodine, in this case even J₂.

In addition to pure metallic halogenides also combinations of metallic halogenides can be used. It has surprisingly been found that this can further improve the effective pressure of lithium or tin to a value which exceeds even the pressure that can be attained when use is made of only a halogenide or a pure halogenide. This effect can be attributed to the formation of so-termed "heterocomplexes" in the gas phase.

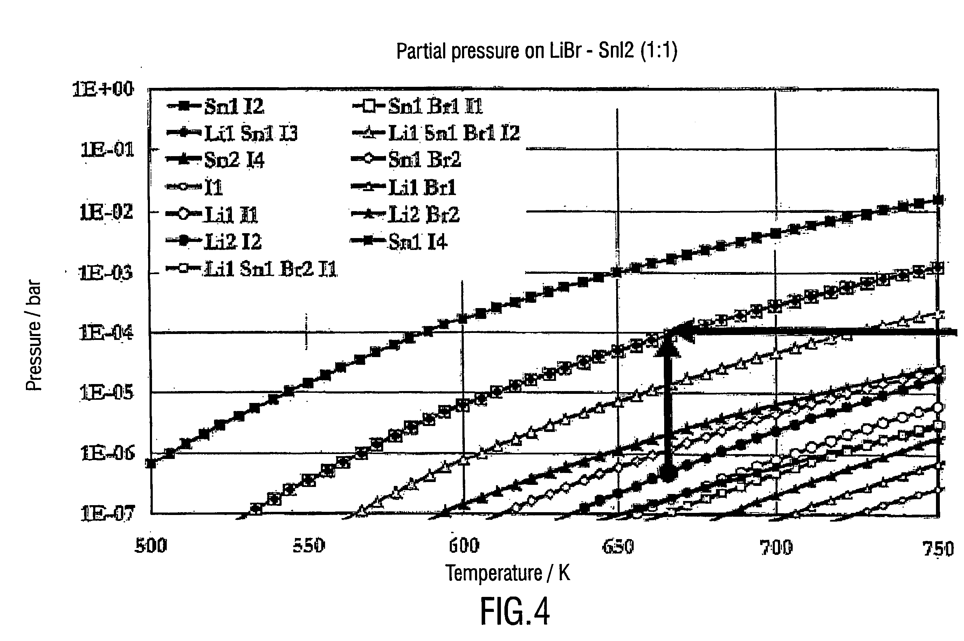

Fig. 4 shows an example of a mixture of equal molar quantities of lithium bromide and tin iodide, use being made of a known method of calculating chemical equilibriums. Fig. 4 shows in detail the complex composition of the resultant gas phase versus the two halogenides. In respect of the EUV discharge source, the most relevant curves are those that relate to lithium or tin-containing chemical compositions.

As is indicated by means of arrows, in comparison with Fig. 1, the temperature necessary to convert the lithium-containing substances to the gas phase at a vapor pressure of 10⁻⁴ bar has been reduced from 800 K to 670 K, which can be attributed to the formation of the gas phase of the complex lithium tin iodide (LiSnJ₃). In other words, the effective pressure of the lithium-containing compositions is improved or increased by more than two orders of magnitude.

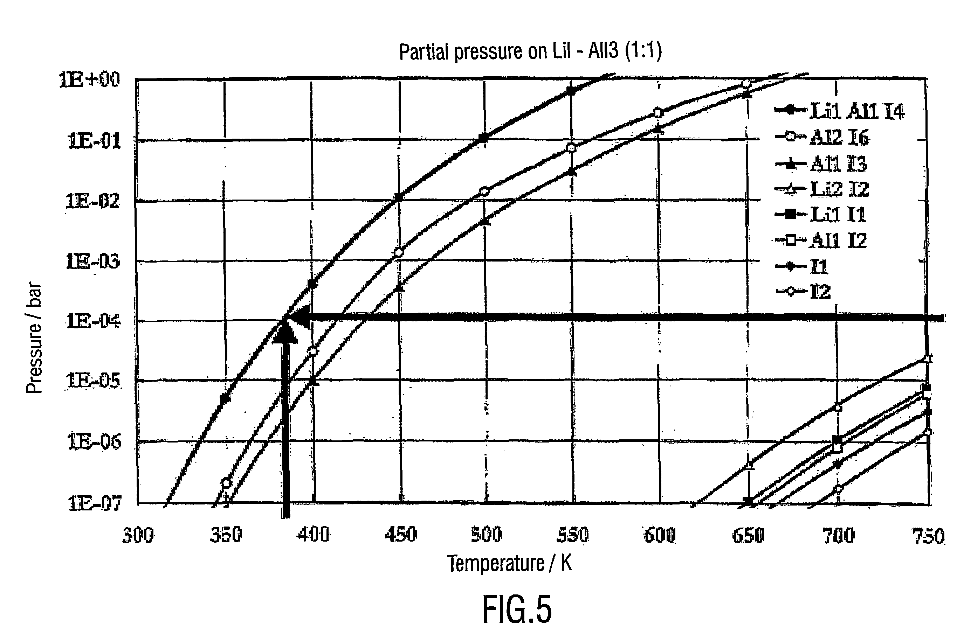

An even more efficient example in respect of the increase of the effective pressure of lithium-containing compositions is shown in Fig. 5. Instead of tin iodide (SnJ₂), aluminum iodide (AlJ₃) is used as a so-termed "evaporator" to build up a high gas phase complex pressure of lithium. As is shown in Fig. 5 by means of the arrows, in comparison with Fig. 1, the temperature necessary to attain 10⁻⁴ bar for lithium-containing compositions in the gas phase has now been reduced from 800 K to 380 K by the formation of the gas phase of the lithium aluminum iodide complex (LiAlJ₄). The lithium pressure is improved by several orders of magnitude with respect to pure lithium iodide, which can be attributed to the formation of the gas phase complex with aluminum.

The invention is not limited to said two examples. Other molar filling ratios of the halogenides are also possible and yield good results. In addition, the selection of metal halogenides containing lithium or tin as well as the selection of "evaporating" metal halogenide, such as tin halogenide or aluminum halogenide, is not limited to the examples of the metal halogenides given hereinabove. The entire range of metallic halogenides and of combinations thereof is possible, including "evaporator" halogenides of, for example, gallium, indium, thallium etc., to obtain a sufficiently increased pressure of lithium or tin-containing compositions in the plasma volume, which is used to generate EUV radiation.

It is known that the high temperatures within the EUV-generating plasma may cause molecules, such as metallic halogenides, to decompose into their elementary constituents. After they have left the plasma region, said constituents may recombine to their original metallic halogenide form. This may occur in the gas volume as well as at the walls of the device, for example at the electrodes in the case of an electric discharge. In many cases however the operating pressure is very low. For example the average free path of the atoms and molecules may be large as compared to the dimensions of the source system. As a result, the recombination of the constituents of the original metallic halogenides may be incomplete. This may possibly lead to the formation of layers or films of metallic constituents near the plasma region, for example at the electrodes of the electric discharge device.

This problem can be precluded by means of an oversaturation of halogens in the system. The additional halogen causes the probability of recombination of the metal and the halogen to be increased, thereby removing the metallic constituents by the formation of volatile metallic halogenides. In this manner, undesirable soiling layers of metallic halogenide constituents can be precluded. In addition, the effective concentration of the metallic halogenide in the region of the plasma can be increased.

As regards the concept and the operation of a plasma-based generation of EUV radiation using the above-mentioned constituents, the following advantages can be achieved:
- The temperature necessary to evaporate the radiant constituents can be noticeably reduced or, equivalent thereto, the pressure or the density of the radiant constituents can be substantially increased. This leads to a substantial reduction of the technical problems associated with the generation and maintenance of hot metal vapors.
- The temperature level, which is necessary to preclude undesirable condensation of metal vapor, can be significantly reduced. This leads to a source design that is technically simpler and to a smaller thermal load on the source materials.
- As a result of said possible lower temperature level, corrosion problems due to aggressive metal vapors can be avoided. As a result the failure risk of the source can be substantially reduced.
- An increased pressure or an increased density of the radiant constituents leads to a higher EUV-generation efficiency.

## Claims

1. A method of generating extreme ultraviolet radiation, wherein the radiant medium is a plasma generated from a basic material distribution, **characterized in that** the basic material distribution of the radiant medium comprises at least one evaporated halogenide of the metals lithium (Li), indium (In), tin (Sn), antimony (Sb), tellurium (Te), aluminum (Al), with the exception of halogenides on the basis of lithium (Li) and chlorine (Cl) as well as fluorine (F).

2. A method as claimed in claim 1, **characterized in that** extreme ultraviolet radiation is generated in the range from approximately 5 nm to approximately 50 nm.

3. A method as claimed in claim 1 or 2, **characterized in that** a plasma with an electron temperature of at least 10 eV is generated.

4. A method as claimed in any one of the claims 1 through 3, **characterized in that** at least an inert gas is added to the basic material distribution.

5. A method as claimed in any one of the claims 1 through 4, **characterized in that** at least a further halogenide, with the exception of halogenides on the basis of lithium (Li) and chlorine (Cl) as well as fluorine (F), is added as a so-termed "evaporator" to the basic material distribution.

6. A method as claimed in claim 5, **characterized in that** said further halogenide is a metal-based halogenide.

7. A method as claimed in any one of the claims 1 through 6, **characterized in that** at least a pure halogen is added to the basic material distribution in a quantity such that an oversaturation condition of the halogen is obtained.

8. A method as claimed in any one of the claims 1 through 7, **characterized in that** the main emission volume of the extreme ultraviolet radiation is below 30 mm³.

9. A method as claimed in any one of the claims 1 through 8, **characterized in that** the extreme ultraviolet radiation is emitted in a wavelength range from 10 to 15 nm.

10. A method as claimed in any one of the claims 1 through 9, **characterized in that** the means for generating the EUV radiation-emitting plasma volume is a discharge taking place between two electrodes.

11. A method as claimed in any one of the claims 1 through 10, **characterized in that** the means for generating the EUV radiation-emitting plasma volume is at least one laser beam.

12. A method as claimed in any one of the claims 1 through 11, **characterized in that** the mean pressure of the metal halogenide, the iodine or another metal halogenide lies in the range from approximately 1 to 1000 Pa.

13. A method as claimed in any one of the claims 1 through 12, **characterized in that** the plasma is generated in the pulsed mode.

14. A method as claimed in any one of the claims 1 through 12, **characterized in that** the plasma is generated in a continuous mode of operation.

15. A method as claimed in any one of the claims 1 through 12, **characterized in that** the plasma is generated by a hollow cathode-triggered discharge.

16. A method as claimed in any one of the claims 1 through 15, **characterized in that** the plasma is formed by a pinch discharge.

17. A method as claimed in any one of the claims 1 through 16, **characterized in that** the basic material distribution of the radiant medium comprises a halogen.

## Patentansprüche

1. Verfahren zur Erzeugung von Extrem-Ultraviolett-Strahlung, wobei das strahlende Medium ein aus einer Basismaterialverteilung erzeugtes Plasma ist, **dadurch gekennzeichnet, dass** die Basismaterialverteilung des strahlenden Mediums mindestens ein verdampftes Halogenid der Metalle Lithium (Li), Indium (In), Zinn (Sn), Antimon (Sb), Tellur (Te), Aluminium (Al) umfasst, mit der Ausnahme von Halogeniden auf der Basis s von Lithium (Li) und Chlor (Cl) sowie Fluor (F).

2. Verfahren nach Anspruch 1, **dadurch gekennzeichnet, dass** Extrem-Ultraviolett-Strahlung im Bereich von ca. 5 nm bis ca. 50 nm erzeugt wird.

3. Verfahren nach Anspruch 1 oder 2, **dadurch gekennzeichnet, dass** ein Plasma mit einer Elektronentemperatur von mindestens 10 eV erzeugt wird.

4. Verfahren nach einem der Ansprüche 1 bis 3, **dadurch gekennzeichnet, dass** mindestens ein Inertgas zu der Basismaterialverteilung hinzugefügt wird.

5. Verfahren nach einem der Ansprüche 1 bis 4, **dadurch gekennzeichnet, dass** mindestens ein weiteres Halogenid, mit der Ausnahme von Halogeniden auf der Basis von Lithium (Li) und Chlor (Cl) sowie Fluor (F), als ein so genannter "Verdampfer" zu der Basismaterialverteilung hinzugefügt wird.

6. Verfahren nach Anspruch 5, **dadurch gekennzeichnet, dass** das genannte weitere Halogenid ein metallbasierendes Halogenid ist.

7. Verfahren nach einem der Ansprüche 1 bis 6, **dadurch gekennzeichnet, dass** mindestens ein reines Halogen in einer derartigen Menge zu der Basismaterialverteilung hinzugefügt wird, dass ein Übersättigungszustand des Halogens erreicht wird.

8. Verfahren nach einem der Ansprüche 1 bis 7, **dadurch gekennzeichnet, dass** das Hauptemissionsvolumen der Extrem-Ultraviolett-Strahlung unter 30 mm³ liegt.

9. Verfahren nach einem der Ansprüche 1 bis 8, **dadurch gekennzeichnet, dass** die Extrem-Ultraviolett-Strahlung in einem Wellenlängenbereich von 10 bis 15 nm emittiert wird.

10. Verfahren nach einem der Ansprüche 1 bis 9, **dadurch gekennzeichnet, dass** das Mittel zum Erzeugen des EUV-Strahlung emittierenden Plasmavolumens eine Entladung ist, die zwischen zwei Elektroden stattfindet.

11. Verfahren nach einem der Ansprüche 1 bis 10, **dadurch gekennzeichnet, dass** das Mittel zum Erzeugen des EUV-Strahlung emittierenden Plasmavolumens mindestens ein Laserstrahlenbündel ist.

12. Verfahren nach einem der Ansprüche 1 bis 11, **dadurch gekennzeichnet, dass** der mittlere Druck des Metallhalogenids, des Jods oder eines anderen Metallhalogenids im Bereich von ca. 1 bis 1000 Pa liegt.

13. Verfahren nach einem der Ansprüche 1 bis 12, **dadurch gekennzeichnet, dass** das Plasma im gepulsten Modus erzeugt wird.

14. Verfahren nach einem der Ansprüche 1 bis 12, **dadurch gekennzeichnet, dass** das Plasma im kontinuierlichen Betriebsmodus erzeugt wird.

15. Verfahren nach einem der Ansprüche 1 bis 12, **dadurch gekennzeichnet, dass** das Plasma durch eine Hohlkathoden-getriggerte Entladung erzeugt wird.

16. Verfahren nach einem der Ansprüche 1 bis 15, **dadurch gekennzeichnet, dass** das Plasma durch eine Pinchentladung gebildet wird.

17. Verfahren nach einem der Ansprüche 1 bis 16, **dadurch gekennzeichnet, dass** die Basismaterialverteilung des strahlenden Mediums ein Halogen umfasst.

## Revendications

1. Procédé de production de rayonnement ultraviolet extrême, dans lequel le milieu rayonnant est un plasma produit à partir d'une distribution de matière de base, **caractérisé en ce que** la distribution de matière de base du milieu rayonnant comprend au moins un halogénure évaporé des métaux de lithium (Li), indium (In), étain (Sn), antimoine (Sb), tellurium (Te), aluminium (Al), à l'exception des halogénures sur la base du lithium (Li) et du chlore (Cl) ainsi que du fluor (F).

2. Procédé selon la revendication 1, **caractérisé en ce que** le rayonnement ultraviolet extrême est produit dans la plage d'environ 5 nm à environ 50 nm.

3. Procédé selon la revendication 1 ou 2, **caractérisé en ce qu'**un plasma avec une température d'électrons d'au moins 10 eV est produit.

4. Procédé selon l'une quelconque des revendications 1 à 3, **caractérisé en ce qu'**au moins un gaz inerte est ajouté à la distribution de matière de base.

5. Procédé selon l'une quelconque des revendications 1 à 4, **caractérisé en ce qu'**au moins un autre halogénure, à l'exception des halogénures sur la base du lithium (Li) et du chlore (Cl) ainsi que du fluor (F), est ajouté en tant que ce qui est appelé « évaporateur » à la distribution de matière de base.

6. Procédé selon la revendication 5, **caractérisé en ce que** ledit autre halogénure est un halogénure à base de métal.

7. Procédé selon l'une quelconque des revendications 1 à 6, **caractérisé en ce qu'**au moins un halogène pur est ajouté à la distribution de matière de base dans une quantité telle qu'une condition de sursaturation de l'halogène est obtenue.

8. Procédé selon l'une quelconque des revendications 1 à 7, **caractérisé en ce que** le volume d'émission principal du rayonnement ultraviolet extrême est inférieur à 30 mm³.

9. Procédé selon l'une quelconque des revendications 1 à 8, **caractérisé en ce que** le rayonnement ultraviolet extrême est émis dans une plage de longueurs d'onde de 10 nm à 15 nm.

10. Procédé selon l'une quelconque des revendications 1 à 9, **caractérisé en ce que** le moyen de production du volume de plasma d'émission de rayonnement ultraviolet extrême est une décharge intervenant entre deux électrodes.

11. Procédé selon l'une quelconque des revendications 1 à 10, **caractérisé en ce que** le moyen de production du volume de plasma d'émission de rayonnement ultraviolet extrême est au moins un faisceau laser.

12. Procédé selon l'une quelconque des revendications 1 à 11, **caractérisé en ce que** la pression moyenne de l'halogénure de métal, de l'iode ou d'un autre halogénure de métal, est dans la plage d'environ 1 Pa à 1000 Pa.

13. Procédé selon l'une quelconque des revendications 1 à 12, **caractérisé en ce que** le plasma est produit dans le mode pulsé.

14. Procédé selon l'une quelconque des revendications 1 à 12, **caractérisé en ce que** le plasma est produit dans un mode de fonctionnement continu.

15. Procédé selon l'une quelconque des revendications 1 à 12, **caractérisé en ce que** le plasma est produit par une décharge déclenchée par cathode creuse.

16. Procédé selon l'une quelconque des revendications 1 à 15, **caractérisé en ce que** le plasma est formé par une décharge par pincement.

17. Procédé selon l'une quelconque des revendications 1 à 16, **caractérisé en ce que** la distribution de matière de base du milieu rayonnant comprend un halogène.
